# FASCICULE DE BREVET EUROPEEN

(11) **EP 2 276 072 B1**
(45) Date de publication et mention de la délivrance du brevet: **16.11.2011**
(21) Numéro de dépôt: 10169281.2
(22) Date de dépôt: 12.07.2010
(51) Int. Cl.: H01L 31/101, H01L 31/103

(54) **Element photodetecteur**
Photodetektorelement
Photodetector element

(30) Priorité: 13.07.2009 FR 0954868
(43) Date de publication de la demande: 19.01.2011
(73) Titulaire: Commissariat à l'Énergie Atomique et aux Énergies Alternatives, 75015 Paris (FR)
(72) Inventeur: Boutami, Salim, 38100, GRENOBLE (FR); Espiau de Lamaestre Roch, 38000, GRENOBLE (FR); Le Perchec, Jérome, 38000, GRENOBLE (FR)
(74) Mandataire: de Beaumont, Michel

(56) Documents cités:
- US-A1- 2006 175 551
- US-A1- 2007 104 411
- LE PERCHEC J ET AL: "Plasmon-based photosensors comprising a very thin semiconducting region" APPLIED PHYSICS LETTERS, AIP, AMERICAN INSTITUTE OF PHYSICS, MELVILLE, NY, US LNKD- DOI:10.1063/1.3132063, vol. 94, no. 18, 7 mai 2009 (2009-05-07), pages 181104-181104, XP012121129 ISSN: 0003-6951

## Description

### Domaine de l'invention

La présente invention concerne un photodétecteur. La présente invention concerne plus particulièrement un photodétecteur comprenant une couche semiconductrice d'une épaisseur inférieure à la longueur d'onde de la lumière que l'on souhaite détecter.

### Exposé de l'art antérieur

Les photodétecteurs actuels comprennent généralement une couche semiconductrice associée à un dispositif de transfert de charges. Lorsqu'un faisceau lumineux éclaire la couche semiconductrice, les photons incidents forment des paires électrons-trous dans celle-ci. Ces porteurs sont ensuite transférés par le dispositif de transfert de charges vers un circuit électronique qui permet leur quantification.

La profondeur moyenne de formation des paires électrons-trous dans une couche semiconductrice dépend de la longueur d'onde du faisceau lumineux incident et du matériau semiconducteur utilisé : plus la longueur d'onde est élevée, plus les paires électrons-trous sont susceptibles de se former profondément dans une couche semiconductrice. Par exemple, pour absorber environ 99 % de lumière rouge, il est nécessaire d'avoir une couche de silicium d'une épaisseur d'environ 10 µm. Pour de la lumière bleue, une couche de silicium ayant une épaisseur de l'ordre de 3 µm suffit à atteindre un tel taux d'absorption. Ces épaisseurs sont très supérieures aux longueurs d'onde des ondes lumineuses que l'on veut détecter et deviennent prohibitives dans le cas de l'infrarouge lointain ou des ondes terahertz.

Dans le cas d'un détecteur d'image, on cherche généralement à réduire la taille des pixels des photodétecteurs élémentaires. La réduction de la surface occupée par chaque pixel sur la couche semiconductrice pose notamment des problèmes d'isolation des régions photosensibles entre elles. En effet, pour éviter des interférences entre pixels voisins, on prévoit généralement de former des tranchées isolantes autour de chacun d'eux. Si la couche semiconductrice est relativement épaisse, les tranchées isolantes occupent une surface non négligeable de la couche semiconductrice, ce qui n'est pas compatible avec la diminution de la taille globale des pixels. On est donc amené à réduire l'épaisseur des couches semiconductrices. Cependant, comme on l'a indiqué précédemment, la formation de couches actives très minces ne permet normalement pas une absorption et une détection de toute la lumière incidente.

On a donc proposé d'augmenter l'épaisseur équivalente de la couche semiconductrice photodétectrice en faisant passer les photons deux ou plusieurs fois dans cette couche. Ainsi, on peut prévoir un miroir d'un côté de la couche semiconductrice pour assurer un double passage dans celle-ci. On peut également prévoir, de part et d'autre de la couche semiconductrice, des éléments réflecteurs pour former des structures de type Fabry-Pérot. En pratique, ces éléments réflecteurs sont des miroirs de Bragg qui sont généralement épais, constitués par exemple d'un empilement de 10 à 30 couches quart d'onde. On perd alors l'avantage de la réduction d'épaisseur de la couche semiconductrice active.

Pour diminuer l'épaisseur des couches semiconductrices de photodétection, on a proposé de tirer profit de phénomènes physiques d'oscillation groupée d'électrons (résonance plasmon). Toutefois, l'utilisation de la résonance plasmon implique généralement la prévision de structures périodiques, ce qui entraîne que le détecteur est très sélectif en longueur d'onde et en angle d'incidence. En outre les structures utilisant la résonance plasmon doivent avoir des dimensionnements extrêmement précis, ce qui conduit à une fabrication difficile. Le document US 2006/17551 divulgue un élément photodétecteur de rayonnement infrarouge présentant une antenne plasmonique.

### Résumé

Par ailleurs, il est souhaitable de pouvoir réaliser des photodétecteurs dans lesquels le matériau semiconducteur puisse être choisi parmi une large gamme de composés semiconducteurs dont certains ne peuvent être déposés qu'en couche extrêmement mince.

Un objet d'un mode de réalisation de la présente invention est de prévoir un photodétecteur comprenant une couche semiconductrice très mince et présentant au moins l'une des caractéristiques suivantes :
- être peu sélectif en fréquence ;
- être pas ou peu réfléchissante dans l'intervalle de réponse ;
- être peu sensible à l'angle d'incidence du faisceau lumineux incident ;
- être peu sensible à la polarisation du faisceau lumineux incident ;
- être capable de sélectionner l'une des deux polarisations fondamentales ; et
- avoir des dimensions inférieures à la longueur d'onde d'un faisceau lumineux à détecter.

Ainsi, un mode de réalisation de la présente invention prévoit un élément photodétecteur d'un rayonnement ayant une longueur d'onde dans le vide voisine d'une valeur λ₀, comprenant une couche semiconductrice d'indice ns et d'épaisseur comprise entre λ₀/4ns et λ₀/20ns ; d'un côté de la couche semiconductrice, un premier milieu d'indice n1 inférieur à ns, transparent à ladite longueur d'onde ; et, de l'autre côté de la couche semiconductrice une région d'un deuxième milieu d'indice n2 inférieur à ns, de largeur L sensiblement égale à λ₀/ns, et, de part et d'autre de ladite région, un troisième milieu, d'indice n3 supérieur à l'indice n2, formant avec le deuxième milieu une interface réflectrice.

Selon un mode de réalisation de la présente invention, la couche semiconductrice a une épaisseur comprise entre λ₀/4ns et λ₀/10ns.

Selon un mode de réalisation de la présente invention, le deuxième milieu est identique au premier milieu.

Selon un mode de réalisation de la présente invention, le deuxième milieu a un indice supérieur à l'indice du premier milieu.

Selon un mode de réalisation de la présente invention, le troisième milieu est métallique.

Selon un mode de réalisation de la présente invention, le troisième milieu a une épaisseur supérieure à λ₀/10.

Selon un mode de réalisation de la présente invention, une couche semiconductrice de HgCdTe est formée sur un substrat de CdTe, le deuxième milieu étant également du CdTe et le troisième milieu étant de l'or.

La présente invention prévoit aussi un assemblage d'éléments photodétecteurs tels que ci-dessus, connectés en parallèle pour constituer un photodétecteur de grande dimension.

Selon un mode de réalisation de la présente invention, l'assemblage comprend des éléments photodétecteurs tels que ci-dessus, connectés séparément pour constituer une matrice de pixels.

Selon un mode de réalisation de la présente invention, l'assemblage comprend des éléments photodétecteurs tels que ci-dessus, adaptés à fonctionner à des longueurs d'ondes identiques ou différentes.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une vue en coupe très schématique destinée à illustrer le principe d'un photodétecteur selon un mode de réalisation de la présente invention ;
la figure 2 est une vue en coupe d'un exemple de réalisation d'un photodétecteur selon un mode de réalisation de la présente invention ; et
les figures 3, 4 et 5 sont des vues de dessus selon le plan de coupe A-A de la figure 2 de photodétecteurs selon divers modes de réalisation de la présente invention.

Comme cela est habituel dans la représentation des composants micro/nanométriques, les diverses figures ne sont pas tracées à l'échelle.

### Description détaillée

Dans la présente description, on désignera par λ₀ la longueur d'onde dans le vide d'un rayonnement à détecter et par λ la longueur d'onde de ce rayonnement dans un milieu considéré. De façon générale, la longueur d'onde λ, dans un milieu sera égale à λ₀/nₑ, ne étant l'indice effectif dans la région correspondant au milieu considéré. On notera que, dans des structures dont les dimensions sont inférieures à la longueur d'onde, cet indice effectif n'est généralement pas strictement égal à l'indice du milieu, mais tient compte des indices des milieux voisins.

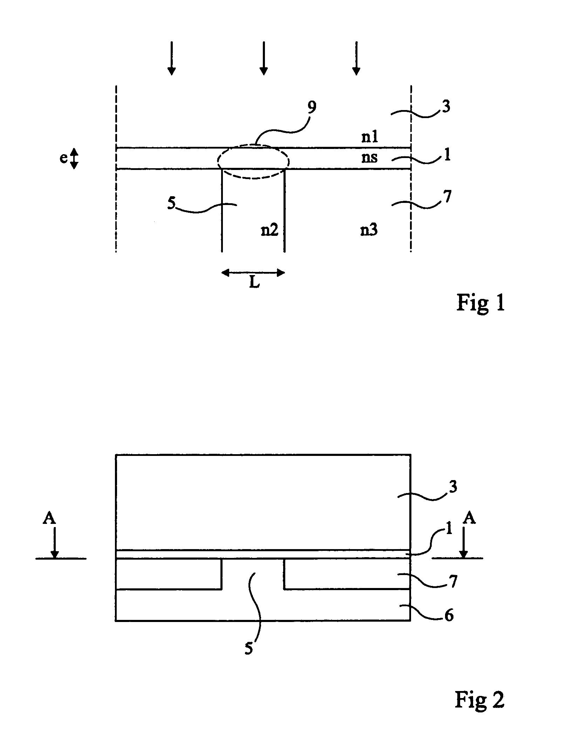

Comme le représente la figure 1, le photodétecteur décrit ici comprend une couche mince 1 d'un matériau semiconducteur d'indice ns, d'épaisseur e nettement inférieure à la longueur d'onde, par exemple comprise entre λ/4 et λ/10, de préférence voisine de λ/4. D'un côté de la couche 1, du côté haut dans la figure, se trouve un milieu transparent 3, d'indice n1. De l'autre côté de la couche 1, se trouve une région 5 d'indice n2, de largeur L sensiblement égale à longueur d'onde effective λ dans la couche 1 d'indice ns. Cette région 5 est encadrée d'une région 7 en un matériau choisi pour que l'interface entre les régions 5 et 7 soit fortement réflectrice, par exemple un matériau métallique, mais aussi, éventuellement, un matériau diélectrique ou semiconducteur d'indice élevé.

Les matériaux des diverses couches et régions sont tels que les indices n1 et n2 sont inférieurs à l'indice ns, et que de préférence n2 est supérieur à n1. Dans ces conditions, on s'aperçoit que la lumière est piégée essentiellement dans la zone 9 entourée de pointillés en figure 1. On peut attribuer le piégeage de la lumière à un double effet de type Fabry-Pérot. D'abord, la lumière est piégée dans la couche mince semiconductrice 1 du fait que cette couche a un indice plus élevé que les milieux voisins d'indices n1 et n2 situés de part et d'autre. De plus, dans la région 5 de largeur λ entre les deux réflecteurs 7, on a un réel effet de Fabry-Pérot, l'interface entre les couches 5 et 7 étant très fortement réflectrice. L'action de cet effet de Fabry-Pérot est renforcée si l'indice n2 de la région 5 est supérieur à l'indice n1 du milieu 3, la lumière ayant alors tendance à aller plus du côté de la région 5 que du côté du milieu 3. De façon générale, les inventeurs ont montré que la hauteur de l'interface entre les régions 5 et 7 doit être au moins égal à λ₀/10.

Cette structure présente l'avantage de donner des caractéristiques qui dépendent peu de l'incidence de la lumière dans une plage d'angles d'incidence par rapport à la normale au plan du détecteur de ± 30°, voire de ± 70° pour certains assemblages de matériaux.

La figure 2 représente un exemple de réalisation pratique du dispositif de la figure 1 dans le cas particulier d'un détecteur dans le domaine de l'infrarouge au voisinage d'une longueur d'onde de 4 µm, la couche mince semiconductrice étant une couche de HgCdTe.

On part d'un substrat 3 en CdTe et on procède aux étapes successives suivantes :
formation par épitaxie sur le substrat d'une couche mince 1 de HgCdTe ;
dépôt sur la couche 1 d'une couche 7, par exemple une couche d'or ;
formation d'une ou plusieurs ouvertures dans la couche 7 ; et
dépôt d'une couche 6 de CdTe dont les parties situées dans les ouvertures dans la couche 7 correspondent aux régions 5 de la figure 1.

Dans le cadre de cet exemple, on constate que l'absorption d'une onde de longueur d'onde voisine de 4 µm est au moins 5 fois plus importante que pour une même couche de HgCdTe entre deux couches de CdTe dépourvues d'ouvertures.

Cet exemple a été donné pour montrer que la structure selon la présente invention est relativement simple à fabriquer par des technologies usuelles. On pourra néanmoins prévoir de nombreuses variantes de réalisation. Par exemple, on pourra au contraire partir de la couche 6 comme substrat et faire croître les autres couches sur ce substrat. La couche semiconductrice 1 est alors formée au moins au dessus de la région 5.

En revenant sur la figure 1, la lumière incidente à partir du haut venant du milieu 3 vers la couche 6 se concentre dans la zone 9, et y crée des paires électrons/trous qu'il faut ensuite mesurer pour obtenir la fonction de photodétecteur. De nombreuses méthodes pourraient être utilisées pour collecter ces charges. On verra ci-après que l'on peut, pour cela, utiliser le matériau de la couche 7 quand il s'agit d'un métal. Pour collecter les électrons et/ou les trous, on pourra aussi former des structures de type diodes latérales et/ou déposer des couches minces conductrices en plus des couches représentées.

Comme on l'a exposé précédemment, le fonctionnement du dispositif décrit ici constitue un photodétecteur ponctuel individuel, et son fonctionnement n'est pas basé sur une structure en réseau. On pourra néanmoins réaliser un assemblage d'une pluralité de photodétecteurs reliés ensemble électriquement ou séparés les uns des autres pour obtenir une détection sur une surface plus importante ou sur une matrice d'images. Dans le cas où les photodétecteurs sont reliés ensemble et sont identiques, on collecte un signal sur une surface plus grande de la surface de chaque photodétecteur pris séparément. Si les photodétecteurs sont différents, on élargit la gamme spectrale du photodétecteur résultant. Dans le cas où on réalise un assemblage de photodétecteurs lus séparément, on obtient une image spatiale de l'absorption ou une image discriminée en longueurs d'ondes. On pourra utiliser pour des photodétecteurs distincts, des largeurs L distinctes des régions 5, par exemple au moins trois largeurs distinctes pour une image trichrome, puisque c'est cette largeur L (égale à λ₀/ns) qui détermine la fréquence centrale du photodétecteur.

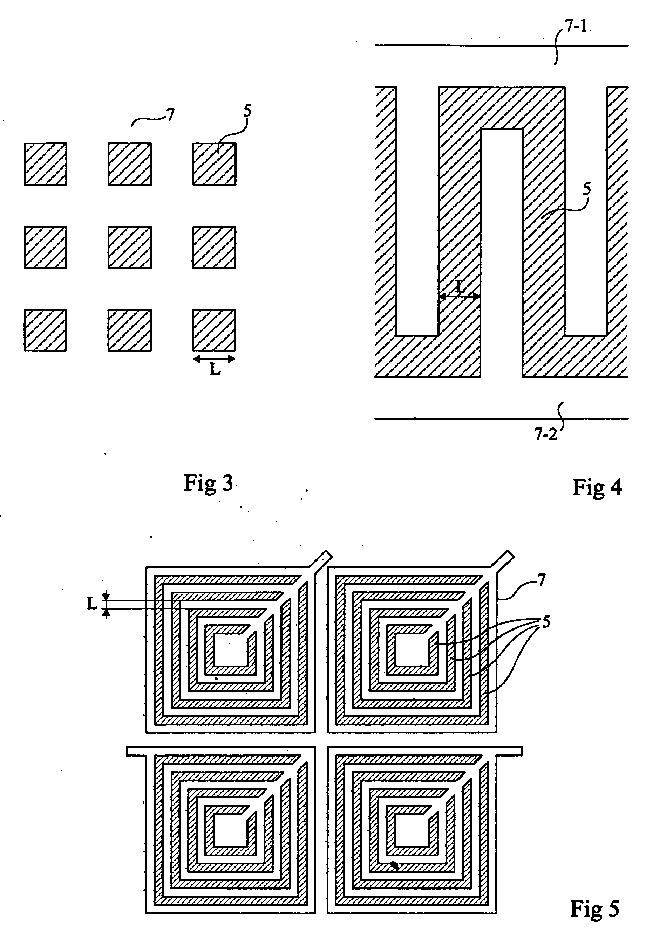

Les figures 3, 4 et 5 sont des vues de dessus dans le plan de coupe A-A de la figure 2 représentant diverses formes possibles d'assemblages de régions 5. On voit dans ces figures des fenêtres 5 formées dans un plan conducteur 7.

Dans le cas de la figure 3, les fenêtres, de dimensions L, sont en forme de carrés. Elles pourront avoir toute autre forme souhaitée. On pourra par exemple envisager des formes en croix dont les bras ont des largeurs λ permettant un dimensionnement spectral plus aisé.

Dans le mode de réalisation de la figure 4, les fenêtres ont la forme de bandes, et ainsi, des électrodes 7-1 et 7-2 peuvent être en forme de peignes pour lire les charges accumulées dans le photodétecteur à l'emplacement des fenêtres 5.

Les figures 3, 4 et 5 ne donnent que des exemples de formes possibles. De nombreuses autres topologies pourront être utilisées. On pourra par exemple prévoir des régions de sections trapézoïdales ou des agencements de formes courbes.

On pourra aussi adopter des formes plus complexes telles que celle représentée à titre d'exemple en figure 5, cette figure étant considérée comme faisant partie intégrante de la présente description. Dans le cas de cette figure, les dimensions d'au moins deux des quatre éléments pourront être distinctes pour détecter au moins deux longueurs d'onde.

Bien entendu la présente invention est susceptible de nombreuses autres variantes. Par exemple, au lieu d'une simple couche semiconductrice, on pourra prévoir des couches d'interface entre la couche semiconductrice 1 et les milieux adjacents. On pourra également prévoir un dépôt successif de régions dopées pour obtenir une structure de diode. On pourra également prévoir la réalisation d'une diode latérale pour permettre des types de lecture particuliers.

Selon le matériau utilisé, la structure résonante décrite peut s'appliquer aux domaines du visible, de l'infrarouge (proche, moyen ou lointain), et même des ondes térahertz.

En ce qui concerne les régions 7, on pourra utiliser des matériaux métalliques très bons réflecteurs et le moins absorbant possible dans la plage de travail à savoir essentiellement des métaux nobles (or, argent, aluminium ainsi que leurs alliages aux propriétés optiques similaires) dans le domaine de l'infrarouge et du visible, des cristaux ioniques (tels que le SiC) et des semiconducteurs fortement dopés dans le domaine de l'infrarouge, et des gaz d'électrons bidimensionnels dans le domaine du térahertz. On pourra utiliser également des matériaux diélectriques et semi-conducteurs à fort indice, par exemple, du silicium pour un détecteur dans le proche infrarouge ou du nitrure de silicium dans le visible.

En ce qui concerne le semiconducteur de la couche 1, on choisira un semiconducteur adapté à la longueur d'onde que l'on veut mesurer. Il pourra s'agir de silicium (cristallin, polycristallin ou amorphe) ou de GaAs pour le visible ; de Ge, InSb, GaSb, InGaAs ou HgCdTe pour l'infrarouge.

Comme on l'a décrit précédemment, dans le cas où la réalisation du photodétecteur commence par le substrat 3, la couche de substrat est en un matériau transparent permettant une croissance de l'un ou l'autre de ces semiconducteurs. On pourra ainsi prévoir les couples substrat/couche absorbante : Ge/Si, SiGe/Si, GaAs/Si, InSb/GaAs, GaSb/GaAs, InGaAs/InP, CdTe/HgCdTe.

S'il est nécessaire de prévoir des couches d'électrodes transparentes, on pourra prévoir des couches d'ITO.

## Revendications

1. Élément photodétecteur d'un rayonnement ayant une longueur d'onde dans le vide voisine d'une valeur λ₀, comprenant :
une couche semiconductrice (1) d'indice ns et d'épaisseur comprise entre λ₀/4ns et λ₀/20ns ;
d'un côté de la couche semiconductrice, un premier milieu (3) d'indice n1 inférieur à ns, transparent à ladite longueur d'onde ;
de l'autre côté de la couche semiconductrice :
- une région (5) d'un deuxième milieu (6) d'indice n2 inférieur à ns, de largeur L sensiblement égale à λ₀/ns, et
- de part et d'autre de ladite région, un troisième milieu (7), d'indice n3 supérieur à l'indice n2, formant avec le deuxième milieu une interface réflectrice.

2. Élément photodétecteur selon la revendication 1, dans lequel la couche semiconductrice (1) a une épaisseur comprise entre λ₀/4ns et λ₀/10ns.

3. Élément photodétecteur selon la revendication 1 ou 2, dans lequel le deuxième milieu (6) est identique au premier milieu (3).

4. Élément photodétecteur selon la revendication 1 ou 2, dans lequel le deuxième milieu (6) a un indice supérieur à l'indice du premier milieu (3).

5. Élément photodétecteur selon l'une quelconque des revendications 1 à 4, dans lequel le troisième milieu (7) est métallique.

6. Élément photodétecteur selon la revendication 5, dans lequel le troisième milieu (7) a une épaisseur supérieure à λ₀/10.

7. Élément photodétecteur selon l'une quelconque des revendications 1 à 6, comprenant une couche semiconductrice de HgCdTe formée sur un substrat de CdTe, le deuxième milieu étant également du CdTe et le troisième milieu étant de l'or.

8. Assemblage d'éléments photodétecteurs selon l'une quelconque des revendications 1 à 7, connectés en parallèle pour constituer un photodétecteur de grande dimension.

9. Assemblage d'éléments photodétecteurs selon l'une quelconque des revendications 1 à 7, connectés séparément pour constituer une matrice de pixels.

10. Assemblage d'éléments photodétecteurs selon l'une des revendications précédentes, comprenant des éléments photodétecteurs adaptés à fonctionner à des longueurs d'ondes identiques ou différentes.

## Claims

1. An element of photodetection of a radiation having a wavelength in vacuum close to a value λ₀, comprising:
a semiconductor layer (1) of index ns and of a thickness ranging between λ₀/4ns and λ₀/20ns;
on one side of the semiconductor layer, a first medium (3) of index n1 smaller than ns, transparent to said wavelength;
on the other side of the semiconductor layer:
- a region (5) of a second medium (6) of index n2 smaller than ns, having a width L substantially equal to λ₀/ns, and
- on either side of said region, a third medium (7), of index n3 greater than index n2, forming a reflective interface with the second medium.

2. The photodetector element of claim 1, wherein the semiconductor layer (1) has a thickness ranging between λ0/4ns and λ₀/10ns.

3. The photodetector element of claim 1 or 2, wherein the second medium (6) is identical to the first medium (3).

4. The photodetector element of claim 1 or 2, wherein the second medium (6) has an index greater than the index of the first medium (3).

5. The photodetector element of any of claims 1 to 4, wherein the third medium (7) is metallic.

6. The photodetector element of claim 5, wherein the third medium (7) has a thickness greater than λ₀/10.

7. The photodetector element of any of claims 1 to 6, comprising an HgCdTe semiconductor layer formed on a CdTe substrate, the second medium also being CdTe and the third medium being gold.

8. An assembly of photodetector elements of any of claims 1 to 7, connected in parallel to form a photodetector of large dimension.

9. The assembly of photodetector elements of any of claims 1 to 7, connected separately to form a pixel array.

10. The assembly of photodetector elements of any of the foregoing claims, comprising photodetector elements, capable of operating at identical or different wavelengths.

## Patentansprüche

1. Ein Photodetektorelement einer Strahlung mit einer Vakuumwellenlänge nahe einem Wert λ₀, wobei das Photodetektorelement Folgendes aufweist:
eine Halbleiterschicht (1) mit einem Index ns und einer Dicke im Bereich zwischen λ₀/4ns und λ₀/20ns;
auf einer Seite der Halbleiterschicht ein erstes Medium (3) mit Index n1, wobei n1 kleiner ist als ns, das für diese Wellenlänge transparent ist;
auf der anderen Seite der Halbleiterschicht:
- einen Bereich (5) eines zweiten Mediums (6) mit Index n2, wobei n2 kleiner ist als ns, mit einer Breite L die im Wesentlichen gleich λ₀/ns ist, und
- auf jeder Seite dieses Bereichs, ein drittes Medium (7) mit Index n3, wobei n3 größer ist als der Index n2, das ein reflektierendes Interface mit dem zweiten Medium bildet.

2. Das Photodetektorelement nach Anspruch 1, wobei die Halbleiterschicht (1) eine Dicke im Bereich zwischen λ₀/4ns und λ₀/10ns aufweist.

3. Das Photodetektorelement nach Anspruch 1 oder 2, wobei das zweite Medium (6) identisch ist mit dem ersten Medium (3).

4. Das Photodetektorelement nach Anspruch 1 oder 2, wobei das zweite Medium (6) einen Index aufweist, der größer ist als der Index des ersten Mediums (3).

5. Das Photodetektorelement nach einem der Ansprüche 1 bis 4, wobei das dritte Medium (7) metallisch ist.

6. Das Photodetektorelement nach Anspruch 5, wobei das dritte Medium (7) eine Dicke größer als λ₀/10 aufweist.

7. Das Photodetektorelement nach einem der Ansprüche 1 bis 6, wobei das Photodetektorelement eine HgCdTe Halbleiterschicht aufweist, die auf einem CdTe Substrat ausgebildet ist, wobei das zweite Medium ebenfalls CdTe ist und das dritte Medium Gold ist.

8. Eine Anordnung von Photodetektorelementen nach einem der Ansprüche 1 bis 7, wobei die Photodetektorelemente parallel geschaltet sind um einen Photodetektor von großer Dimension zu bilden.

9. Die Anordnung von Photodetektorelementen nach einem der Ansprüche 1 bis 7, wobei die Photodetektorelemente separat geschaltet sind, um ein Pixelarray zu bilden.

10. Die Anordnung von Photodetektorelementen nach einem der vorhergehenden Ansprüche, wobei die Anordnung Photodetektorelemente aufweist, die geeignet sind bei identischen oder unterschiedlichen Wellenlängen betrieben zu werden.
